# EUROPÄISCHE PATENTSCHRIFT

(11) **EP 2 693 492 B1**
(45) Veröffentlichungstag und Bekanntmachung des Hinweises auf die Patenterteilung: **15.02.2017**
(21) Anmeldenummer: 12005551.2
(22) Anmeldetag: 31.07.2012
(51) Int. Cl.: H01L 31/048, H01L 31/02, H01L 31/054

(54) **Solarzelleneinheit**
Solar cell unit
Unité de cellules solaires

(43) Veröffentlichungstag der Anmeldung: 05.02.2014
(73) Patentinhaber: AZUR SPACE Solar Power GmbH, 74072 Heilbronn (DE)
(72) Erfinder: Zrinscak, Ivica, 74074 Heilbronn (DE)
(74) Vertreter: Koch Müller Patentanwaltsgesellschaft mbH

(56) Entgegenhaltungen:
- EP-A1- 2 073 279
- EP-A1- 2 312 646
- DE-A1-102007 012 504
- DE-A1-102011 084 054
- US-A1- 2009 120 500
- US-A1- 2011 017 295
- ANONYMOUS: 'Polycarbonate - Wikipedia, the free encyclopedia', [Online] 14 März 2014, XP055107865 Gefunden im Internet: <URL:http://en.wikipedia.org/wiki/Polycarbo nate> [gefunden am 2014-03-14]

## Beschreibung

Die Erfindung betrifft eine Solarzelleneinheit gemäß dem Oberbegriff des Patentanspruchs 1.

Aus der EP 2 073 279 A1 ist ein Solarzellenmodul bekannt, bei dem ein als Solarzelle ausgebildeter Halbleiterkörper auf einem Träger angeordnet ist. Um den Halbleiterkörper und insbesondere dessen Seitenflächen vor Umgebungseinflüssen zu schützen, die zu einer Degradation der elektrischen Parameter führen, wird um den Halbleiterkörper an vier Seiten ein Rahmen angeordnet und mit einem transparenten Deckel abgeschlossen. Anschließend wird der verbleibende Zwischenraum mit einer transparenten Vergussmasse aufgefüllt und ein optisches Element angebracht.

Aus der EP 1 953 825 A2 ist eine weitere Solarzelleneinheit bekannt. Hierbei wird auf einem Träger ein als Solarzelle ausgebildeter Halbleiterkörper angeordnet. Anschließend werden zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.

Aus der DE 10 2009 006 286 A1 ist eine Solarzelleneinheit bekannt, welches eine Vielzahl von einzelnen Solarzellen auf einem Träger aufweist. Unter anderem ist oberhalb der Solarzelle ein optisches Element, welches auch als sekundäres optisches Element bezeichnet "SOE" wird, angeordnet. Das optische Element leitet das durch eine Fresnellinse fokussierte Licht der Sonne auf die Oberfläche der Solarzelle. Mittels der fokussierenden Anordnung lassen sich mit wenigen kleinen Solarzellen, welche einen Wirkungsgrad bis zu 40% und darüber aufweisen, großflächige Solarzelleneinheiten aufbauen.

Aus der EP 2 312 646 A1, der DE 10 2007 012504 A1, der US 2009/120500 A1 und der DE 10 2011 084054 A1 sind Halbleiterkörper und Gehäuseanordnungen bekannt. Ein konzentriertes photovoltaisches Systemmodul ist aus der US 2011 / 001 7295 A1 bekannt.

Vor diesem Hintergrund besteht die Aufgabe der Erfindung darin, eine Vorrichtung anzugeben, die den Stand der Technik weiterbildet.

Die Aufgabe wird durch eine Solarzelleneinheit mit den Merkmalen des Patentanspruchs 1 gelöst. Vorteilhafte Ausgestaltungen der Erfindung sind Gegenstand von Unteransprüchen.

Gemäß dem Gegenstand der Erfindung eine Solarzelleneinheit mit einem als Solarzelle ausgebildeten Halbleiterkörper offenbart, wobei der Halbleiterkörper eine Vorderseite mit einem ersten elektrischen Anschlusskontakt und eine Rückseite mit einem zweiten elektrischen Anschlusskontakt und eine zwischen der Vorderseite und der Rückseite ausgebildete Seitenfläche aufweist, und die Solarzelleneinheit einen Träger mit einer Oberseite und einer Unterseite und einen auf der Oberseite als Teil des Trägers ausgebildeten ersten Leiterbahnbereich und einen zweiten Leiterbahnbereich aufweist, wobei die beiden Leiterbahnbereiche elektrisch voneinander isoliert sind und der erste Leiterbahnbereich an den ersten Anschlusskontakt elektrisch angeschlossen ist und der zweite Anschlusskontakt mit dem zweiten Leiterbahnbereichs elektrisch verschaltet Ist, indem die Rückseite des Halbleiterkörper mit einem Teil des zweiten Leiterbahnbereichs kraftschlüssig verbunden ist, und mit einem sekundären optischen Element, das eine Unterseite aufweist , einstückig aus einer Quarzglasverbindung ausgebildet ist, und Licht auf die Vorderseite des Halblelterkörpers führt, wobei das sekundäre optische Element an der Unterseite in einem zentralen Bereich erste Ausformung aufweist und die erste Ausformung eine gegenüber der umgebenden Fläche der Unterseite erhöht ist und eine plane Oberfläche aufweist und die Oberfläche der ersten Ausformung auf der Vorderseite des Halbleiterkörpers angeordnet und mit dem Halbleiterkörper kraftschlüssig verbunden ist und an der Unterseite des sekundären optischen Elements beabstandet von dem zentralen Bereich eine zweite Ausformung als umlaufenden Rand ausgebildet ist und die zweite Ausformung gegenüber der die zweite Ausformung umgebenden Fläche der Unterseite erhöht ist und zwischen der ersten Ausformung und der Vorderseite des Halbleiterkörpers und in einem ersten Raum zwischen der ersten Ausformung und der zweiten Ausformung einerseits und der Oberseite des Trägers andererseits eine Polymerkleberschicht ausgebildet ist, um das sekundäre optische Element mit dem Halbleiterkörper und mit dem Träger kraftschlüssig zu verbinden.

Es sei angemerkt, dass es sich bei der Solarzelle vorzugsweise um eine III-V Halbleitersolarzelle auf GaAs Basis handelt und die Solarzelle höchst vorzugsweise als stapelförmig angeordnete Mehrfachsolarzelle ausgebildet ist und unter anderem mittels Nutzung von UV-Lichtanteilen Wirkungsgrade oberhalb 30% aufweist. Derartige Solarzelleneinheiten werden, unter anderem wegen den im Vergleich zu den Siliziumsolarzellen höheren Herstellkosten, bevorzugt in sogenannten CPV-Systemen eingesetzt. In den CPV-Systemen wird das Sonnenlicht um Faktoren oberhalb von 50 gebündelt. Hierbei wird das mittels eines primären optischen Konzentrators bzw. Elements gebündelte Licht auf ein sekundäres optisches Element geleitet. Das Primäre Element ist oberhalb des sekundären optischen Elements angeordnet. Von dem sekundären optischen Element wird das Licht durch die Polymerkleberschicht hindurch auf die Vorderseite der Solarzelle geleitet.

Um die optischen Verluste gering zu halten, muss die Polymerkleberschicht neben einer hohen UV-Beständigkeit auch in dem gesamten auszunutzenden Spektralbereich besonders transparent ausgebildet sein. Außerdem werden durch die hohe Konzentration des Sonnenlichtes hohe Temperaturen bis zu 120°C auf der Vorderseite der Solarzelle erzielt, d. h. die Polymerkleberschicht muss besonders temperatur- und alterungsbeständig ausgeführt sein.

Ein Vorteil der erfindungsgemäßen Vorrichtung ist es, dass mit der ersten Ausformung, wobei die erste Ausformung in der Größe und Form auf die Größe und die Form der Vorderseite des Halbleiters abgestimmt ist, das sekundäre optische Element, um einen hohen Transmissionsgrad des auf das sekundäre optische Element einfallenden Lichts zu erzielen. Indem zwischen der Unterseite des sekundären optischen Elements und der Oberseite des Trägers bzw. der Vorderseite der Solarzelle eine Polymerkleberschicht, die vorzugsweise eine Kunststoffverbindung und höchst vorzugsweise eine Silikonverbindung umfasst, ausgebildet ist, lässt sich ohne weitere Verbindungsmittel eine kraftschlüssige Verbindung auf einfache und kostengünstige Weise herstellen. Es versteht sich, dass zwischen Vorderseite der Solarzelle und der Unterseite des sekundären optischen Elements die Polymerkleberschicht eine geringe Dicke, vorzugsweise unterhalb 2 mm, höchst vorzugsweise unterhalb 0,5 mm ausgebildet ist.

Es zeigt sich, dass die Polymerkleberschicht dichtende Eigenschaften aufweist und die Oberseite des Trägers sowie den Halbleiterkörper und insbesondere die Seitenflächen des Halblelterkörpers durch die Polymerkleberschicht zuverlässig vor Umgebungseinflüssen geschützt sind. Anders ausgedrückt stellt die Polymerkleberschicht eine Vergussmasse dar. Die Vergussmasse ist zwischen der gesamten Unterseite des sekundären optischen Elements und an der Oberseite des Trägers ausgebildet, wobei die Vorderseite des Halbleiterkörpers und die Seitenflächen des Halbleiterkörpers formschlüssig überdeckt sind. Die Polymerkleberschicht kissenartig und formschlüssig den gesamten ersten Raum zwischen der Unterseite des sekundären optischen Elementes innerhalb des umlaufenden Randes d. h. der zweiten Ausformung und der Oberseite des Trägers ausfüllt. Ein Vorteil ist, dass mittels der zweiten Ausformung eine vorgegebene Begrenzung für die laterale Ausdehnung der Polymerkleberschicht vorhanden ist. Mittels der zweiten Ausformung wird eine zusätzliche Abdichtung des innerhalb der zweiten Ausformung liegenden Bereichs erzielt.

Bei einer Ausführungsform ist die zweite Ausformung oberhalb der ersten Leiterbahnbereichs und oberhalb des zweiten Leiterbahnbereichs erniedrigt. Hierdurch lässt sich mittels des Randes, d. h. mittels der zweiten Ausformung eine besonders formschlüssige Anordnung mit der Oberseite des Trägers erzielen. Des Weiteren ist es bevorzugt, dass die zweite Ausformung entlang der Längserstreckung der zweiten Ausformung zu einem überwiegenden Teil eine größere Höhe als die Höhe der ersten Ausformung aufweist. Hierdurch wird eine unmittelbare Auflage der Oberfläche der ersten Ausformung auf der Vorderseite des Halbleiterkörpers vermieden.

In einer besonders bevorzugten Ausführungsform ist die zweite Ausformung von dem äußeren Rand der Unterseite beabstandet und bildet mit der zweiten Ausformung einen Falz aus. Ein Vorteil ist, dass der Falz sich mit einer Polymerdichtschicht ausfüllen lässt und die Polymerdichtschicht mittels der zweiten Ausformung umlaufend vollständig von der Polymerkleberschicht separieren lässt. Untersuchungen haben gezeigt, dass mittels der Ausbildung eines Falzes für die Polymerkleberschicht an der Unterseite des sekundären optischen Elements eine große Oberfläche zur Haftung an dem sekundären optischen Element ausbilden und die Abdichtung des innerhalb der zweiten Ausformung liegenden Bereichs gegen Umgebungseinflüssen erhöhen lässt. Vorzugsweise läst sich als Polymerdichtschicht Polyurethan verwenden. In einer ersten Alternative schließt die Polymerdichtschicht bündig mit der äußeren Kante des sekundären optischen Elements ab. In einer zweiten Alternative umschließt die Polymerdichtschicht ein Teil der unmittelbar an die Unterseite angrenzenden Seitenflächen des sekundären optischen Elements. Hierdurch lässt sich die Abdichtung gegen Umgebungseinflüsse und die kraftschlüssige Verbindung des sekundären optischen Elements mit dem Träger weiter erhöhen.

In einer anderen Weiterbildung weist der Träger wenigstens in einer Richtung vorzugsweise in beiden innerhalb der Oberseitenebene des Trägers ausgebildeten Richtungen eine größere laterale Ausdehnung als das sekundäre optische Element auf. Hierdurch ist der äußere Rand der Unterseite des sekundären optischen Elements von dem äußeren Rand auf der Oberseite des Träges beabstandet und die Fläche der Oberseite größer als die Fläche der Unterseite des sekundären optischen Elements.

Gemäß einer bevorzugten Ausführungsform ist auf der Oberseite des Trägers in dem ersten Raum eine Schutzdiode, vorzugsweise ausgebildet als Bypassdiode, angeordnet und mit dem ersten Leiterbahnbereich und dem zweiten Leiterbahnbereich verschaltet. Die Schutzdiode ist kraftschlüssig mit der Oberseite des Trägers verbunden. Es sei angemerkt, dass die Solarzelle auch eine Diodencharakteristik aufweist und die Schutzdiode antiparallel zu der Solarzelle geschaltet ist. Die aus der Oberseite des Trägers hervorstehenden Flächen der Schutzdiode sind vorzugsweise von der Polymerkleberschicht bedeckt.

In einer bevorzugten Ausführungsform ist das sekundäre optische Element in Form eines halben Ellipsolds ausgebildet und weist vorzugsweise einen umlaufenden absatzförmigen Kragen auf. In einer anderen Ausführungsform ist das sekundäre optische Element pyramidenstumpfförmig oder trichterförmig ausgebildet. Das sekundäre optische Element ist einstückig aus einer Quarzglasverbindung ausgebildet. Ein Vorteil der Quarzglasverbindung ist die sehr gute UV-Transparenz und die außerordentliche hohe Temperaturstabilität sowie eine große mechanische und chemische Widerstandsfähigkeit im Vergleich zu einer organischen bzw. KunststoffVerbindung.

Bei einer Weiterbildung ist der Träger plattenförmig ausgebildet und umfasst vorzugsweise eine Keramikverbindung. Untersuchungen haben gezeigt, eine keramische Verbindung eine ausreichende chemische, mechanische und Temperaturstabilität aufweist. Bei einer anderen Weiterbildung ist an der Unterseite des Trägers eine Metallschicht als Teil des Trägers ausgebildet, wobei die Metallschicht vorzugsweise in einem umlaufenden Randbereich unmittelbar am Rand des Trägers nicht ausgebildet ist. Ein Vorteil der Metallschicht ist, dass gegenüber einem Träger ohne rückseitige Metallsicht, die Wärme von der Oberseite des Trägers gleichmäßiger auf den gesamten Träger übertragen wird. Untersuchungen haben gezeigt, dass durch die gleichmäßigere Verteilung der Wärme auch eine höhere Abstrahlung von der Rückseite erfolgt. Ferner lässt sich bei einer Montage des Trägers auf einer Unterlage mittels der rückseitigen Metallschicht der Wärmeübergangswiderstand zwischen der Unterlage und dem Träger reduzieren.

In einer Weiterbildung ist zwischen der Oberfläche der ersten Ausformung und der Polymerkleberschicht eine erste Haftvermittlerschicht ausgebildet ist. In einer alternativen Ausführungsform ist die erste Haftvermittlerschicht an der gesamten Unterseite des sekundären optischen Elements ausgebildet und mit der Unterseite stoffschlüssig verbunden. Untersuchungen haben gezeigt, dass sich die Haftung zwischen der Polymerkleberschicht und der weitestgehend planen Unterseite des sekundären optischen Elements mit der Ausbildung einer dünnen Haftvermittlerschicht wesentlich erhöhen und hierdurch die Zuverlässigkeit steigern lässt. In einer anderen Weiterbildung ist zwischen der Polymerkleberschicht und der Vorderseite des Halbleiterkörpers eine zweite Haftvermittlerschicht ausgebildet und die zweite Haftvermittlerschicht mit der Vorderseite des Halbleiterkörpers stoffschlüssig verbunden. Mit der Ausbildung der zweiten Haftvermittlerschicht lässt sich die Zuverlässigkeit weiter erhöhen. Gemäß einer alternativen Ausführungsform ist die zweite Haftvermittlerschicht auch auf der Oberseite des Trägers ausgebildet. Es ist bevorzugt, die erste Haftvermittlerschicht und / oder die zweite Haftvermittlerschicht transparent und sehr dünn auszuführen, vorzugsweise beträgt die Dicke weniger als 0,5 mm, höchst vorzugsweise weniger als 0,05 mm.

Es versteht sich, dass die beiden Haftvermittlerschichten im Vergleich zu der Polymerkleberschicht und zu der Polymerdichtschicht eine unterschiedliche chemische Zusammensetzung aufweisen. Des Weiteren sei angemerkt, dass die Polymerkleberschicht und die Polymerdichtschicht eine unterschiedliche chemische Zusammensetzung aufweisen.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnittsansicht entlang einer Linie I-I auf eine erfindungsgemäße Ausführungsform einer Solarzelleneinheit,
- Figur 2: eine Draufsicht auf die Ausführungsform der Figur 1 mit einer Schutzdiode,
- Figur 3: eine Querschnittsansicht entlang einer Linie II-II auf die Ausführungsform der Figur 2,
- Figur 4: eine perspektivische Ansicht von unten auf das sekundäre optische Element, dargestellt in der Fig. 2,
- Figur 5: eine Draufsicht von Oben auf die Oberseite des Trägers dargestellt in der Figur 2.

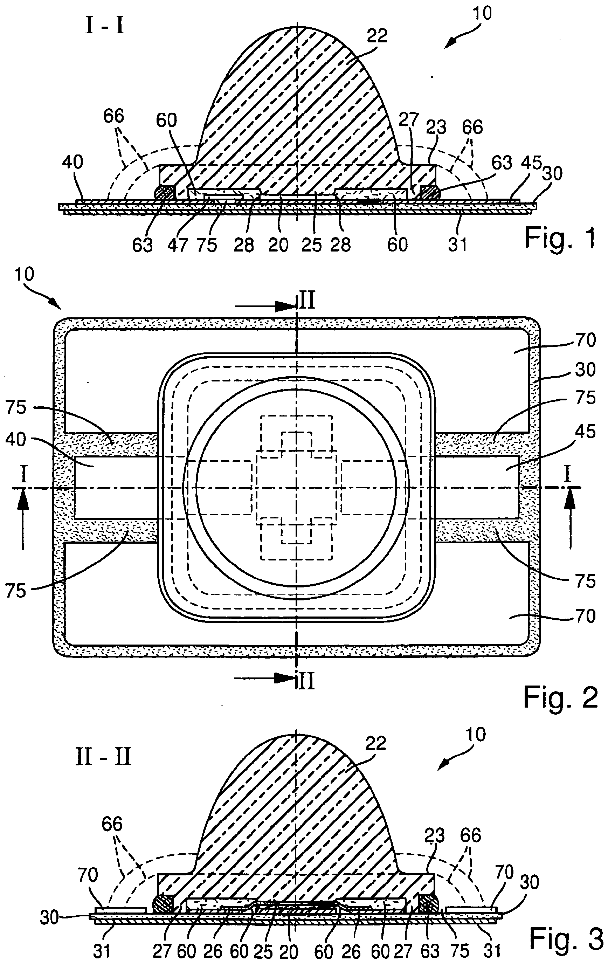

Die Abbildung der Figur 1 zeigt eine Solarzelleneinheit 10 in einer Querschnittsansicht entlang einer Linie I-I mit einem als Solarzelle ausgebildeten Halbleiterkörper 20, einem sekundären optischen Element 22 in Form eines halben Ellipsoids mit einem umlaufenden kragenförmigen Wulst 23. Das sekundäre optische Element 22 weist eine Unterseite 24. auf. In einem zentralen Bereich ist eine gegenüber der umgebenden Fläche erhöhte erste Ausformung 25 ausgebildet, wobei die erhöhte erste Ausformung 25 eine plane Oberfläche aufweist. Ferner ist an der Unterseite 24 des sekundären optischen Elements 22 beabstandet von dem zentralen Bereich eine zweite Ausformung 27 als umlaufenden Rand ausgebildet, wobei die zweite Ausformung 27 gegenüber der die zweite Ausformung 27 umgebenden Fläche der Unterseite 24 erhöht ist. Die zweite Ausformung 27 weist entlang der Längserstreckung der zweiten Ausformung 27 zu einem überwiegenden Teil eine größere Höhe als die Höhe der ersten Ausformung 25 auf. Hierdurch wird eine unmittelbare Auflage der Oberfläche der ersten Ausformung 25 auf der Vorderseite des Halbleiterkörpers 20 vermieden. Die zweite Ausformung 27 ist von dem äußeren Rand der Unterseite 24 des sekundären optischen Elements 22 beabstandet. Hierdurch wird ein Falz ausgebildet. Ein Vorteil des Falzes ist es, dass sich in den Falz eine weitere Dichtmasse einbringen lässt, wobei mittels der zweiten Ausformung 27 die die Dichtmasse sich von der Polymerkleberschicht separieren lässt.

Das optische Element 22 führt das in das sekundäre optische Element 22 einfallende Licht auf die Vorderseite des Halbleiterkörpers 20, wobei die Oberfläche der ersten Ausformung 25 oberhalb einer Vorderseite des Halbleiterkörpers 20 angeordnet und mit dem Halbleiterkörper 20 kraftschlüssig verbunden ist. Ferner weist der Halbleiterkörper 20 eine Vorderseite mit einem ersten elektrischen Anschlusskontakt und eine Rückseite mit einem zweiten elektrischen Anschlusskontakt und eine zwischen der Vorderseite und der Rückseite ausgebildete Seitenfläche 28 auf. Der Halbleiterkörper 20 ist mit der Rückseite auf einer Oberseite eines Trägers 30 kraftschlüssig verbunden.

An der Unterseite weist der Träger 30 eine bis auf einen schmalen Randbereich ganzflächige Metallschicht 31 auf. Außerdem weist der Träger 30 eine größere laterale Ausdehnung als das sekundäre optische Element 22 auf. An der Oberseite des Trägers 30 ist ein erster als Teil des Trägers ausgebildeter Leiterbahnbereich 40 ausgebildet. Der erste Leiterbahnbereich 40 ist mit dem ersten elektrischen Anschlusskontakt mittels zwei Schweißverbinder Verbindern 26 elektrisch verschaltet. Des Weiteren weist der Träger 30 auf der Oberseite einen zweiten als Teil des Trägers 30 ausgebildeten Leiterbahnbereich 45 auf. Der zweite Leiterbahnbereich 45 und der zweite elektrische Anschlusskontakt sind miteinander elektrisch verschaltet, indem die Rückseite des Halbleiterkörpers 20 auf dem zweiten Leiterbahnbereich 45 aufgelötet ist. Ferner sind auf der Oberseite des Trägers 30 zwei Schutzdioden angeordnet. Die Schutzdioden sind als Bypass-Dioden 47 ausgebildet. Es versteht sich, dass mit einer anderen Dimensionierung der Schutzdioden auch eine einzelne Schutzdiode hinreichend ist.

Zwischen der ersten Ausformung 25 und der Vorderseite des Halbleiterkörpers 20 und in einem ersten Raum gebildet zwischen der ersten Ausformung 25 und der zweiten Ausformung 27 einerseits und der Oberseite des Trägers 30 mit den Schutzdioden und der Vorderseite des Halbleiterkörpers 20 andererseits ist eine Polymerkleberschicht ausgebildet, um das sekundäre optische Element 22 mit dem Halbleiterkörper 20 und mit dem Träger 30 kraftschlüssig zu verbinden.

Die Polymerkleberschicht ist vorzugsweise als eine Silikonschicht 60 ausgebildet. Die Silikonschicht 60 füllt in Form einer Vergussmasse den ersten Raum formschlüssig vollständig aus. Die Silikonschicht 60 überdeckt sowohl die Seitenflächen des Halbleiterkörpers 20 als auch die aus der Oberseite des Trägers 30 herausstehenden Flächen der Schutzdiode. Die Silikonschicht 60 ist kissenförmig ausgebildet und endet an der Unterseite 24 an dem inneren Rand der zweiten Ausformung 27. Ein Vorteil ist, dass mittels der zweiten Ausformung 27 eine vorgegebene Begrenzung für die laterale Ausdehnung der Polymerkleberschicht vorhanden ist. Mittels der zweiten Ausformung 27 wird die abdichtende Eigenschaft der Polymerkleberschicht des innerhalb der zweiten Ausformung 27 liegenden Bereichs erhöht.

In dem Falz ist eine Polymerdichtschicht 63 angeordnet, wobei die Polymerdichtschicht 63 den Falz umlaufend vollständig ausfüllt. Die Polymerdichtschicht 63 ist mittels der zweiten Ausformung 27 von der Polymerkleberschicht separiert. Vorzugsweise wird als Polymerdichtschicht 63 Polyurethan verwendet. Mittels der Ausbildung eines Falzes für die Polymerkleberschicht 63 wird die Haftung zwischen dem sekundären optischen Element 22 und dem Träger 30 und die Abdichtung des innerhalb der zweiten Ausformung 27 liegenden Bereichs gegenüber Umgebungseinflüssen erhöht. In einer ersten Alternative schließt die Polymerdichtschicht 63 mit der äußeren Kante des sekundären optischen Elements ab. In einer zweiten Alternative dargestellt durch gestrichelte Linien 66 umschließt die Polymerdichtschicht 63 ein Teil der unmittelbar an die Unterseite 24 angrenzenden Seitenflächen des sekundären optischen Elements 22. Hierdurch lässt sich die Abdichtung gegen Umgebungseinflüsse und die kraftschlüssige Verbindung des sekundären optischen Elements mit dem Träger weiter erhöhen.

In einer nicht dargestellten alternativen Ausführungsform ist an der gesamten Unterseite 24 eine stoffschlüssig mit der Unterseite 24 verbundene erste Haftvermittlerschicht ausgebildet. Ferner ist in einer anderen nicht dargestellten alternativen Ausführungsform auf der Vorderseite des Halbleiterkörpers 20 eine zweite Haftvermittlerschicht ausgebildet, wobei die zweite Haftvermittlerschicht mit der Vorderseite des Halbleiterkörpers stoffschlüssig verbunden ist. In einer ebenfalls nicht darstellten Weiterbildung überdeckt die zweite Haftvermittlerschicht wenigstens einen Teil der Oberseite des Trägers 30. Es versteht sich, dass die erste Haftvermittlerschicht und / oder die zweite Haftvermittlerschicht eine im Vergleich zu der Polymerkleberschicht unterschiedliche chemische Zusammensetzung aufweisen.

Die Abbildung der Figur 2 zeigt eine Draufsicht auf die Ausführungsform der Figur 1. Nachfolgend werden nur die Unterschiede zu der Darstellung In der Figur 1 erläutert. Es zeigt sich, dass die laterale Ausdehnung des sekundären optischen Elements 22 inklusive des umlaufenden Kragens 23 kleiner als die Ausdehnung des Trägers 30 ist. Zur Veranschaulichung sind die beiden Schweißverbinder 26 mit denen die Vorderseite des Halbleiterkörpers 20 elektrisch angeschlossen sind, als gestrichelte Linien gezeichnet. Der erste Leiterbahnbereich 40 und der zweite Leiterbahnbereich 45 sind entlang der Linie I-I in einem mittleren Bereich des Trägers 30 ausgebildet und voneinander beabstandet. Eine elektrische Verbindung der beiden Leiterbahnbereiche 40 und 45 ist mittels des Halbeliterkörpers 20 und mittels der Schutzdioden gegeben. In den um die beiden Leiterbahnbereiche 40 und 45 umgebenden Bereiche auf der Oberseite des Trägers 30 sind weitere zwei Metallflächen 70 angeordnet. Die Metallflächen 70 sind elektrisch von den beiden Leiterbahnbereichen 40 und 45 isoliert.

Die Abbildung der Figur 3 zeigt einen weiteren Querschnitt entlang der Linie II-II auf die Ausführungsform der Figur 2. Nachfolgend werden nur die Unterschiede zu den Darstellungen in den Figur 1 und 2 erläutert. Es zeigt sich dass zwischen den beiden Metallflächen 70 und den beiden Leiterbahnbereichen 40 und 45 eine Aussparung 75 ausgebildet ist und die zweite Ausformung 27 mit der Unterseite der zweiten Ausformung auf dem Träger 30 aufliegt. Des Weiteren ist die Vorderseite der Solarzelle an zwei sich gegenüberliegenden Randbereichen mittels der beiden Schweißverbinder 26 mit dem ersten Leiterbahnbereich 40 elektrisch verschaltet.

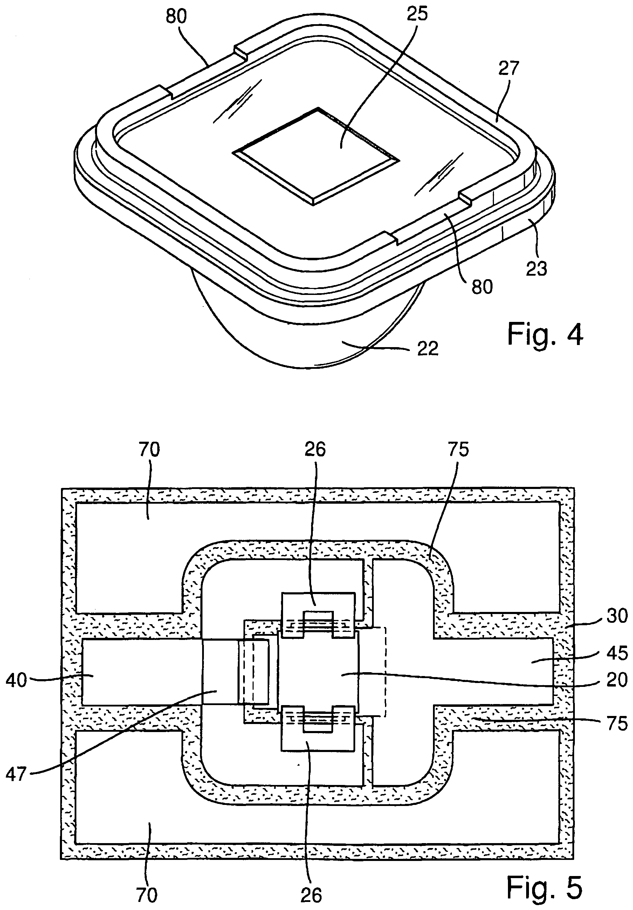

Die Abbildung der Figur 4 zeigt eine perspektivische Ansicht von unten auf das sekundäre optische Element 22, dargestellt in der Figur 2. Nachfolgend werden nur die Unterschiede zu den Darstellungen in den Figuren 1 bis 3 erläutert. Dei zweite Ausformung 27 ist umlaufend ausgebildet und an zwei sich gegenüberliegenden Abschnitten 80 in der Höhe erniedrigt. Die beiden Abschnitte 80 sind in einem gefügten Zustand jeweils oberhalb des ersten Leiterbahnbereichs 40 bzw. oberhalb des Leiterbahnbereichs 45 ausgebildet. In Längserstreckung der Abschnitte 80 ist durch die Breite des ersten Leiterbahnbereichs 40 und durch die Breite des zweiten Leiterbahnbereichs 45 bestimmt. Des Weiteren ist Größe der Absenkung der Abschnitte 80 gegenüber der Höhe in dem weiteren Verlauf der zweiten Ausformung 27 durch die Dicke des ersten Leiterbahnbereichs 40 und durch die Dicke des zweiten Leiterbahnbereichs 45 bestimmt. Hierdurch bildet in einer zusammengesetzten Ausführung die zweite Ausformung 27 eine formschlüssige Anordnung mit der Oberseite des Trägers 30 aus.

Die Abbildung der Fig. 5 zeigt eine Draufsicht von Oben auf die Oberseite des Trägers dargestellt in der Figur 2. Nachfolgend werden nur die Unterschiede zu den Darstellungen in den Figuren 1 bis 3 erläutert. Es zeigt sich, dass die beiden Metallflächen 70 mittels der Aussparung 75 von dem ersten Leiterbahnbereich 40 und dem zweiten Leiterbahnbereich 45 elektrisch isoliert sind. Die beiden Metallflächen 70 sind jeweils als Teil des Trägers 30 ausgebildet und erhöhen durch die im Vergleich zu dem keramischen Träger 30 wesentlich höheren Wärmeleitfähigkeit die Wärmeverteilung auf dem Träger und hierdurch die Größe der Wärmeabstrahlung.

## Patentansprüche

1. Solarzelleneinheit (10) mit
- einem als Solarzelle ausgebildeten Halbleiterkörper (20), aufweisend eine Vorderseite und eine Rückseite und mit zwischen der Vorderseite und der Rückseite des Halbleiterkörpers (20) ausgebildete Seitenflächen (28) und wobei auf der Vorderseite ein erster elektrischer Anschlusskontakt und auf der Rückseite ein zweiter elektrischer Anschlusskontakt ausgebildet sind,
- einem Träger (30) mit einer Oberseite und einer Unterseite und einen auf der Oberseite als Teil des Trägers (30) ausgebildeten ersten Leiterbahnbereich (40) und zweiten Leiterbahnbereich (45), wobei die beiden Leiterbahnbereiche (40, 45) elektrisch voneinander beabstandet sind und der erste Leiterbahnbereich (40) an den ersten Anschlusskontakt elektrisch angeschlossen ist und der zweite Anschlusskontakt mit dem zweiten Leiterbahnbereich (45) elektrisch verschaltet ist, indem die Rückseite des Halbleiterkörpers (20) mit einem Teil des zweiten Leiterbahnbereichs (45) kraftschlüssig verbunden ist, und
- einem sekundären optischen Element (22), wobei das sekundäre optische Element Licht auf die Vorderseite des Halbleiterkörpers (20) führt, und das sekundäre optische Element (22) eine Unterseite aufweist,
**dadurch gekennzeichnet, dass**
das sekundäre optische Element (22) einstückig aus einer Quarzglasverbindung ausgebildet ist und an der Unterseite in einem zentralen Bereich eine erste Ausformung (25) aufweist und die erste Ausformung (25) eine gegenüber der umgebenden Fläche der Unterseite erhöht ist und eine plane Oberfläche aufweist und die Oberfläche der ersten Ausformung auf der Vorderseite des Halbleiterkörpers (20) angeordnet und mit dem Halbleiterkörper (20) kraftschlüssig verbunden ist und an der Unterseite (24) des sekundären optischen Elements (22) beabstandet von dem zentralen Bereich eine zweite Ausformung (27) als umlaufender Rand ausgebildet ist und die zweite Ausformung (27) gegenüber der die zweite Ausformung (27) umgebenden Fläche der Unterseite (24) erhöht ist und zwischen der ersten Ausformung (25) und der Vorderseite des Halbleiterkörpers (20) und in einem ersten Raum zwischen der ersten Ausformung (25) und der zweiten Ausformung (27) einerseits und der Oberseite des Trägers (30) andererseits eine Polymerkleberschicht ausgebildet ist, um das sekundäre optische Element (22) mit dem Halbleiterkörper (20) und mit dem Träger (30) kraftschlüssig zu verbinden.

2. Solarzelleneinheit (10) nach Anspruch 1, **dadurch gekennzeichnet, dass** die zweite Ausformung (27) oberhalb des ersten Leiterbahnbereichs (40) und oberhalb des zweiten Leiterbahnbereichs (45) erniedrigt ist.

3. Solarzelleneinheit (10) nach Anspruch 1 oder 2, **dadurch gekennzeichnet, dass** die Polymerkleberschicht eine Kunststoffverbindung umfasst.

4. Solarzelleneinheit (10) nach einem der Ansprüche 1 bis 3, **dadurch gekennzeichnet, dass** die zweite Ausformung (27) entlang der Längserstreckung der zweiten Ausformung (27) zu einem überwiegenden Teil eine größere Höhe als die erste Ausformung (25) aufweist.

5. Solarzelleneinheit (10) nach einem der Ansprüche 1 bis 4, **dadurch gekennzeichnet, dass** die zweite Ausformung (27) von dem äußeren Rand der Unterseite (24) beabstandet ist und der äußere Rand der Unterseite (24) mit der zweiten Ausformung einen Falz ausbildet.

6. Solarzelleneinheit (10) nach einem der Ansprüche 1 bis 5, **dadurch gekennzeichnet, dass** in dem ersten Raum eine Schutzdiode angeordnet und die Schutzdiode kraftschlüssig mit der Oberseite des Trägers (30) verbunden ist.

7. Solarzelleneinheit (10) nach einem der Ansprüche 1 bis 6, **dadurch gekennzeichnet, dass** die Polymerkleberschicht den ersten Raum vollständig ausfüllt und eine Silikonverbindung (60) umfasst.

8. Solarzelleneinheit (10) nach einem der Ansprüche 1 bis 7, **dadurch gekennzeichnet, dass** das sekundäre optische Element (22) linsenförmig oder trichterförmig ausgebildet ist.

9. Solarzelleneinheit (10) nach einem der Ansprüche 1 bis Z 8, **dadurch gekennzeichnet, dass** der äußere Rand der Unterseite des sekundären optischen Elements (22) von dem äußeren Rand auf der Oberseite des Trägers (30) beabstandet ist und die Fläche der Oberseite größer als die Fläche der Unterseite des sekundären optischen Elements (22) ist.

10. Solarzelleneinheit (10) nach einem der Ansprüche 1 bis 9, **dadurch gekennzeichnet, dass** der Träger (30) plattenförmig ausgebildet ist und eine Keramikverbindung umfasst.

11. Solarzelleneinheit (10) nach einem der Ansprüche 1 bis 10, **dadurch gekennzeichnet, dass** an der Unterseite des Trägers (30) eine Metallschicht (31) ausgebildet ist.

12. Solarzelleneinheit (10) nach einem der Ansprüche 1 bis 11, **dadurch gekennzeichnet, dass** zwischen der Oberfläche der ersten Ausformung (25) und der Polymerkleberschicht eine erste Haftvermittlerschicht und / oder zwischen der Vorderseite des Halbleiterkörpers (20) und der Polymerkleberschicht eine zweite Haftvermittlerschicht ausgebildet ist.

13. Solarzelleneinheit (10) nach einem der Ansprüche 1 bis 12, **dadurch gekennzeichnet, dass** die Polymerkleberschicht die Unterseite (24) des optischen Elements (22) überdeckt und ein Teil der unmittelbar an die Unterseite (24) angrenzenden Seitenflächen des sekundären optischen Elements (22) umschließt.

## Claims

1. Solar cell unit (10) comprising
- a semiconductor body (20) which is constructed as a solar cell and has a front side and a rear side, with side surfaces (28) formed between the front side and the rear side of the semiconductor body (20), wherein a first electrical terminal contact is formed on the front side and a second electrical terminal contact is formed on the rear side,
- a support (30) with an upper side and a lower side and with a first conductor track region (40) and second conductor track region (45) formed on the upper side as part of the support (30), wherein the two conductor track regions (40, 45) are electrically spaced from one another and wherein the first conductor track region (40) is electrically connected with the first terminal contact and the second terminal contact is electrically connected with the second conductor track region (45) in that the rear side of the semiconductor body (20) is connected by friction couple with a part of the second conductor track region (45), and
- a secondary optical element (22), wherein the secondary optical element conducts light to the front side of the semiconductor body (20) and the secondary optical element (22) has a lower side,
**characterised in that**
the secondary optical element (22) is formed integrally from a quartz-glass composite and has at the lower side in a central region a first shaped portion (25) which is elevated relative to the surrounding surface of the lower side and which has a flat surface, the surface of the first shaped portion being arranged on the front side of the semiconductor body (20) and being connected by friction couple with the semiconductor body (20),
a second shaped portion (27) is formed as an encircling edge at the lower side (24) of the secondary optical element (22) at a spacing from the central region, the second shaped portion (27) being elevated relative to the surface, which surrounds the second shaped portion (27), of the lower side (24),
and a polymer adhesive layer is formed between the first shaped portion (25) and the front side of the semiconductor body (20) and in a space between the first shaped portion (25) and the second shaped portion (27) on the one hand and the surface of the support (30) on the other hand so as to connect the secondary optical element (22) by friction couple with the semiconductor body (20) and with the support (30).

2. Solar cell unit (10) according to claim 1, **characterised in that** the second shaped portion (27) is lowered down above the first conductor track region (40) and above the second conductor track region (45).

3. Solar cell unit (10) according to claim 1 or 2, **characterised in that** the polymer adhesive layer comprises a synthetic material compound.

4. Solar cell unit (10) according to any one of claims 1 to 3, **characterised in that** the second shaped portion (27) has for a predominant part along the length direction of the second shaped portion (27) a greater height than the first shaped portion (25).

5. Solar cell unit (10) according to any one of claims 1 to 4, **characterised in that** the second shaped portion (27) is spaced from the outer edge of the lower side (24), and the outer edge of the lower side (24) together with the second shaped portion forms a rebate.

6. Solar cell unit (10) according to any one of claims 1 to 5, **characterised in that** a protective diode is arranged in the first space and the protective diode is connected with the upper side of the support (30) by friction couple.

7. Solar cell unit (10) according to any one of claims 1 to 6, **characterised in that** the polymer adhesive layer completely fills out the first space and comprises a silicon compound (60).

8. Solar cell unit (10) according to any one of claims 1 to 7, **characterised in that** the secondary optical element (22) is formed to be lens-shaped or funnel-shaped.

9. Solar cell unit (10) according to any one of claims 1 to 8, **characterised in that** the outer edge of the lower side of the secondary optical element (22) is spaced from the outer edge on the upper side of the support (30) and the area of the upper side is greater than the area of the lower side of the secondary optical element (22).

10. Solar cell unit (10) according to any one of claims 1 to 9, **characterised in that** the support (30) is formed to be plate-shaped and comprises a ceramic compound.

11. Solar cell unit (10) according to any one of claims 1 to 10, **characterised in that** a metal layer (31) is formed at the lower side of the support (30).

12. Solar cell unit (10) according to any one of claims 1 to 11, **characterised in that** a first adhesion-promoting layer is formed between the surface of the first shaped portion (25) and the polymer adhesive layer and/or a second adhesion-promoting layer is formed between the front side of the semiconductor body (20) and the polymer adhesive layer.

13. Solar cell unit (10) according to any one of claims 1 to 12, **characterised in that** the polymer adhesive layer covers the lower side (24) of the optical element (22) and surrounds a part of the side surfaces, which directly adjoin the lower side (24), of the secondary optical element (22).

## Revendications

1. Unité de cellule solaire (10) avec:
- un corps semi-conducteur (20) réalisé sous forme de cellule solaire, présentant un côté avant et un côté arrière et avec des faces latérales (28) formées entre le côté avant et le côté arrière du corps semi-conducteur (20) et dans laquelle on a formé sur le côté avant une première borne de raccordement électrique et sur le côté arrière une deuxième borne de raccordement électrique,
- un support (30) avec un côté supérieur et un côté inférieur et une première zone de voies conductrices (40) et une deuxième zone de voies conductrices (45) formées sur le côté supérieur faisant partie du support (30), dans laquelle les deux zones de voies conductrices (40, 45) sont espacées électriquement l'une de l'autre et la première zone de voies conductrices (40) est raccordée électriquement à la première borne de raccordement eL la deuxième borne de raccordement est connectée électriquement à la deuxième zone de voies conductrices (45), par le fait que le côté arrière du corps semi-conducteur (20) est assemblé par adhérence à une partie de la deuxième zone de voies conductrices (45), et
- un élément optique secondaire (22), dans laquelle l'élément optique secondaire conduit de la lumière sur le côté avant du corps semi-conducteur (20), et l'élément optique secondaire (22) présente un côté inférieur,
**caractérisé en ce que**
l'élément optique secondaire (22) est réalisé en une seule pièce à partir d'un composé de verre de quartz et il présente sur le côté inférieur un premier renflement (25) dans une région centrale et le premier renflement (25) est surélevé par rapport à la surface environnante du côté inférieur et présente une surface plane et la surface du premier renflement est disposée sur le côté avant du corps semi-conducteur (20) et est assemblée par adhérence avec le corps semi-conducteur (20) et un deuxième renflement (27) est formé sur le côté inférieur (24) de l'élément optique secondaire (22) comme bord périphérique à distance de la région centrale et le deuxième renflement (27) est surélevé par rapport à la surface du côté inférieur (24) entourant le deuxième renflement (27) et une couche de colle polymère est formée entre le premier renflement (25) et le côté avant du corps semi-conducteur (20) et dans un premier espace entre le premier renflement (25) et le deuxième renflement (27) d'une part et le côté supérieur du support (30) d'autre part, afin d'assembler par adhérence l'élément optique secondaire (22) au corps semi-conducteur (20) et au support (30).

2. Unité de cellule solaire (10) selon la revendication 1, **caractérisée en ce que** le deuxième renflement (27) est réduit au-dessus de la première zone de voies conductrices (40) et au-dessus de la deuxième zone de voies conductrices (45).

3. Unité de cellule solaire (10) selon la revendication 1 ou 2, **caractérisée en ce que** la couche de colle polymère comprend un composé de matière plastique.

4. Unité de cellule solaire (10) selon l'une quelconque des revendications 1 à 3, **caractérisée en ce que** le deuxième renflement (27) présente dans une majeure partie le long de l'extension longitudinale du deuxième renflement (27) une plus grande hauteur que le premier renflement (25).

5. Unité de cellule solaire (10) selon l'une quelconque des revendications 1 à 4, **caractérisée en ce que** le deuxième renflement (27) est espacé du bord extérieur du côté inférieur (24) et le bord extérieur du côté inférieur (24) forme un sertissage avec le deuxième renflement.

6. Unité de cellule solaire (10) selon l'une quelconque des revendications 1 à 5, **caractérisée en ce qu'**une diode de protection est disposée dans le premier espace et la diode de protection est assemblée par adhérence au côté supérieur du support (30).

7. Unité de cellule solaire (10) selon l'une quelconque des revendications 1 à 6, **caractérisée en ce que** la couche de colle polymère remplit entièrement le premier espace et comprend un composé de silicone (60).

8. Unité de cellule solaire (10) selon l'une quelconque des revendications 1 à 7, **caractérisée en ce que** l'élément optique secondaire (22) est réalisé en forme de lentille ou en forme d'entonnoir.

9. Unité de cellule solaire (10) selon l'une quelconque des revendications 1 à 8, **caractérisée en ce que** le bord extérieur du côté inférieur de l'élément optique secondaire (22) est espacé du bord extérieur sur le côté supérieur du support (30) et la surface du côté supérieur est plus grande que la surface du côté inférieur de l'élément optique secondaire (22).

10. Unité de cellule solaire (10) selon l'une quelconque des revendications 1 à 9, **caractérisée en ce que** le support (30) est réalisé en forme de plaque et comprend un composé de céramique.

11. Unité de cellule solaire (10) selon l'une quelconque des revendications 1 à 10, **caractérisée en ce qu'**une couche métallique (31) est formée sur le côté inférieur du support (30).

12. Unité de cellule solaire (10) selon l'une quelconque des revendications 1 à 11, **caractérisée en ce qu'**une première couche d'agent adhésif est formée entre la surface du premier renflement (25) et la couche de colle polymère et/ou une deuxième couche d'agent adhésif est formée entre le côté avant du corps semi-conducteur (20) et la couche de colle polymère.

13. Unité de cellule solaire (10) selon l'une quelconque des revendications 1 à 12, **caractérisée en ce que** la couche de colle polymère recouvre le côté inférieur (24) de l'élément optique (22) et enveloppe une partie des faces latérales de l'élément optique secondaire (22) directement adjacentes au côté inférieur (24).
